Europäisches Patentamt

European Patent Office

Office européen des brevets

(11) Numéro de publication: **0 375 505**
**A1**

## DEMANDE DE BREVET EUROPEEN

(21) Numéro de dépôt: 89403438.8

(22) Date de dépôt: 12.12.89

(51) Int. Cl.⁵: **H01G 1/035**

(30) Priorité: 20.12.88 FR 8816810

(43) Date de publication de la demande:
27.06.90 Bulletin 90/26

(84) Etats contractants désignés:
**BE DE FR GB IT**

(71) Demandeur: **COMPAGNIE EUROPEENNE DE COMPOSANTS ELECTRONIQUES LCC**
**50, rue Jean-Pierre Timbaud**
**F-92400 Courbevoie(FR)**

(72) Inventeur: **Dorlanne, Olivier**
**THOMSON-CSF SCPI Cédex 67**
**F-92045 Paris La Défense(FR)**

(74) Mandataire: **Guérin, Michel et al**
**THOMSON-CSF SCPI**
**F-92045 PARIS LA DEFENSE CEDEX 67(FR)**

(54) **Composant électrique à report direct.**

(57) Le composant électrique de l'invention est tel que, de forme parallélépipédique, chacune d'au moins deux de ses faces latérales opposées (10 et 12) est équipée d'un élément (4a,4b ; 5a,5b) de chacune des deux électrodes (4,5) de connexion du composant.

Fig. 1

## COMPOSANT ELECTRIQUE A REPORT DIRECT

La présente invention concerne un composant électrique (ou électronique) à report direct sur un circuit imprimé, par opposition au report par enfichage.

On préfère de plus en plus, dans le secteur électronique, l'utilisation de composants pour montage en surface qui présentent de nombreux avantages par rapport aux composants enfichables. On citera pour mémoire, une miniaturisation plus poussée, une fiabilité plus importante, un gain de poids, une amélioration de la vitesse de transfert du signal, une meilleure résistance aux vibrations.... Ils offrent en outre une plus grande facilité de montage au moyen de lignes de fabrication automatique.

Ce type de composant peut être passif ou actif. Ce peut être un élément capacitif ou une varistance, cette dernière étant utilisée dans le domaine de la protection contre les surtensions électriques.

On connaît deux types de composants de ce type, sous forme de "chip ", selon qu'ils sont protégés par une simple couche de protection (comme dans le document européen 229 286) ou qu'ils sont noyés dans une résine de protection comme c'est le cas des dispositifs selon les documents japonais JP. 86 219 440 ou JP. 86 235 478.

Les dispositifs du premier type présentent des électrodes de connexion du composant qui sont symétriques par rapport à un plan longitudinal médian du composant. En d'autres termes, chacune des faces parallèles opposées par lesquelles le "chip" peut être connecté au circuit imprimé possède chacune deux électrodes. Cette disposition géométrique permet de supprimer une opération d'orientation pour présenter le composant au niveau du circuit imprimé, ce qui est avantageux dans le cas d'une alimentation automatique. Leurs principaux inconvénients résident dans le fait qu'ils n'offrent guère de résistance en atmosphère chaude et humide à cause d'une différence trop importante dans les coefficients de dilatation des différents éléments du composant (céramique, verre, métal) et une solidarisation par contact et pressage de ces éléments.

En ce qui concerne les dispositifs du second type, la résistance à une atmosphère agressive est satisfaisante, mais la symétrie des électrodes n'existe pas si bien qu'il convient d'orienter le composant avant sa mise en place sur circuit imprimé.

La présente invention entend allier les avantages des deux types de composants ci-dessus en éliminant leurs inconvénients.

A cet effet, l'invention a donc pour objet un composant électrique à report direct en surface, noyé dans une masse parallélépipédique d'enrobage protecteur dont certaines surfaces extérieures portent des électrodes de connexion planes, dans lequel chacune d'au moins deux surfaces parallèles opposées du parallélépipède est équipée d'un élément de chacune des deux électrodes de connexion du composant.

Dans un premier mode de réalisation, ce composant comprend un élément actif ou passif possédant deux terminaisons électriques auxquelles sont raccordées les électrodes, qui est logé dans un boîtier parallélépipédique ouvert par l'une de ses faces, les électrodes étant constituées par des feuillards conformés en crochets de suspension de l'élément, recouvrant chacun l'un des bords opposés de l'ouverture du boîtier, les feuillards se prolongeant le long des faces du boîtier terminées par les bords susdits, et possédant un retour, à l'autre extrémité de ces faces, dirigé sous le boîtier parallèlement à la partie du feuillard en appui sur les bords susdits.

Ce boîtier est de préférence rempli de résine polymérisée. Dans une variante, il est refermé par un couvercle dans le même matériau que le boîtier, ce qui confère au composant une même apparence visuelle quelle que soit la face sous laquelle il est vu.

Dans un autre mode de réalisation, le feuillard formant chaque électrode est issu de la masse d'enrobage par la partie médiane d'une face d'extrémité, pour l'une des électrodes et de la partie médiane de la face opposée pour l'autre électrode, ce feuillard étant refendu pour former des pattes repliées contre la face d'où il est issu de part et d'autre de son plan, chaque patte possédant un retour sur la face du parallélépipède contigüe à cette face d'extrémité.

L'invention sera mieux comprise au cours de la description donnée ci-après de deux modes de réalisation, à titre purement indicatif et non limitatif.

Il sera fait référence aux dessins annexés dans lesquels :
- la figure 1 est une vue en coupe d'un premier mode de réalisation de l'invention,
- la figure 2 est une coupe d'une variante de réalisation de la figure 1,
- la figure 3 est un schéma d'un second mode de réalisation d'un composant selon l'invention après le surmoulage de l'élément actif ou passif dans la résine,
- la figure 4 montre le composant de la figure 3 dans sa configuration finale.

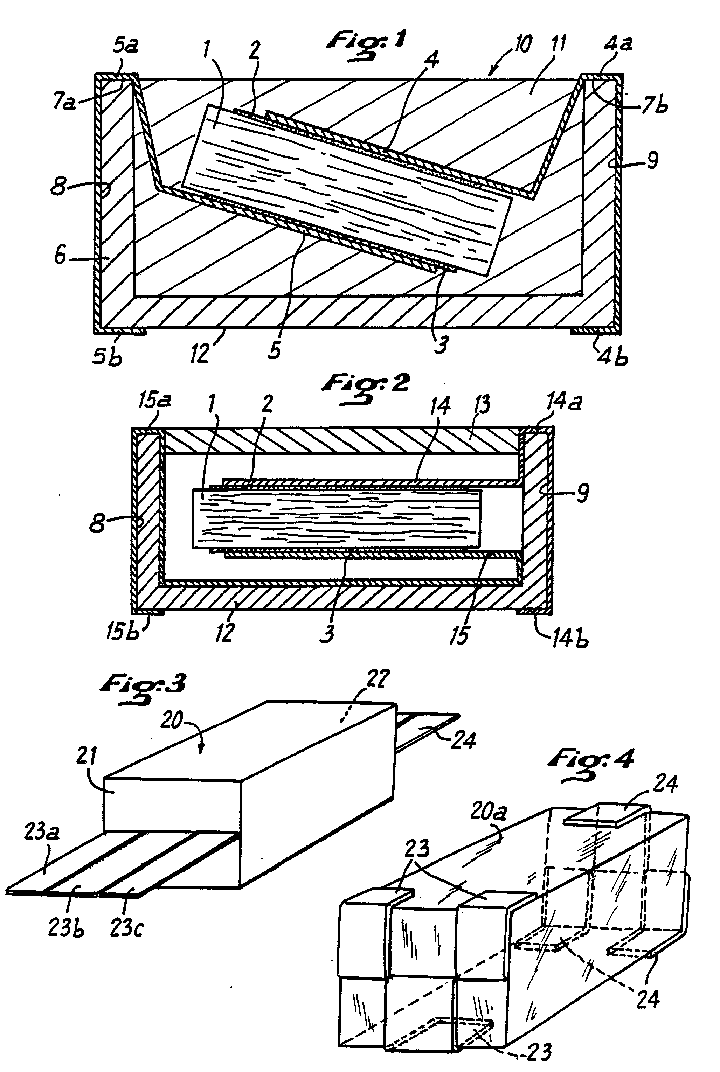

Sur ces figures, on a représenté en 1 une varistance en céramique (oxyde de zinc auquel sont ajoutés un certain nombre d'oxydes additifs selon une technique connue de l'homme de métier). Cette céramique se présente sous la forme d'un disque ou d'un parallélépipède et deux faces opposées de cet élément sont métallisées. La couche métallique 2, 3 peut être une pâte d'argent déposée par sérigraphie. Un feuillard métallique 4,5 est fixé par tout moyen connu aux couches métalliques 2, 3. Ce feuillard peut être une portion de bande de connexion telle qu'elle a pu être décrite dans le document français n° 2 581 827. Dans le procédé de fabrication du composant selon l'invention, la céramique 2 équipée de ses feuillards 4,5, est placée dans un boîtier 6 de manière que chaque feuillard 4,5 prenne appui sur le bord supérieur 7a, 7b de deux faces opposées 8 et 9 du boîtier 6, ces bords limitant l'ouverture 10 du boîtier par laquelle l'élément 1 est introduit dans le boîtier. L'inclinaison de la céramique 1, comme représentée en figure 1, dans le boîtier, permet d'avoir deux feuillards 4 et 5 de longueur identique. On voit sur la figure qu'au moyen d'une presse on peut mettre en forme les feuillards 4 et 5 en forme de crochets s'appuyant sur les bords 7a, 7b des parois 8 et 9. Le boîtier est ensuite rempli de résine 11 résistant à la soudure à la vague, soit sous vide ou dans l'air suivant la résine, de manière à noyer la céramique 1 dans le boîtier 6, et cette résine est polymérisée en subissant un cycle thermique approprié. Les feuillards 4 et 5 sont ensuite repliés pour longer les faces 8 et 9 du boîtier et posséder un retour sous le fond 12 de ce dernier. Ainsi terminé, le composant comporte sur chacune des deux faces parallèles opposées deux électrodes 5a, 4a ou 5b, 4b, qui sont identiques. La mise en place par report en surface de ce composant, peut indifféremment se faire par l'une ou l'autre de ces faces.

L'intérêt de la disposition de la figure 1 réside dans le fait que les feuillards 4 et 5 (qui forment bande de connexion) sont de longueur égale.

La disposition de la figure 2 fait apparaître une céramique 1 de laquelle les pattes de connexion 14 et 15 sont issues d'un même côté. Ceci peut être avantageux du point du vue de la mise en place de la céramique entre les pattes 14, 15, notamment pour l'opération de soudure. On voit alors que la bande conductrice 14 est repliée pour entourer la paroi 9 du boîtier 6, alors que la bande conductrice 15 forme un retour pour longer intérieurement le fond 12 pour ensuite entourer la paroi 8. De même que dans le cas précédent, le volume intérieur du boîtier 6 est rempli de résine polymérisée. En outre, on met en place un couvercle 13, introduit à force ou calé dans l'ouverture du boîtier, pour donner à ce dernier une même apparence visuelle quelle que soit la face sous laquelle il est aperçu. De même qu'en regard de la figure précédente, chacune de deux faces parallèles du composant comporte deux électrodes de connexion 15a, 14a et 15b, 14b.

Les figures 3 et 4 illustrent un autre mode de réalisation du composant selon l'invention. La bande de connexion, qui sert à la réalisation des électrodes en assurant dans le surmoulage la continuité électrique entre l'extérieur et les faces métallisées de l'élément actif ou passif et qui assure le rôle de support et d'entraînement de tous les composants au cours de leur fabrication, est soudée à ces faces argentées par tout procédé connu. La bande de connexion est généralement en laiton étamé avec une sous-couche de cuivre. Elle peut être également en ferronickel ou cupronickel étamés.

La bande de connexion est alors placée dans une presse qui permet grâce à une forme adaptée du moule, de surmouler la céramique d'une résine époxyde chargée 20 par transfert ou un polysulfure de phénylène par injection. Dans ce cas, la bande de connexion sert avantageusement de plan de joint lors du surmoulage.

Les feuillards qui ensuite sont pliés pour former les électrodes, sont constitués par les portions de bande de connexion qui, découpées et séparées du reste de la bande, sont en saillie du surmoulage. Dans le cas de la figure 3, ils se présentent sous la forme de trois pattes parallèles sortant du composant par la partie médiane de deux faces d'extrémités opposées 21, 22. Les pattes 23a, 23b, 23c forment une électrode, tandis que les autres 24 forment une autre électrode. Par pliage, on réalise le composant représenté en figure 4 qui lui aussi présente deux électrodes 23, 24. Dans ce mode de réalisation comme dans le mode de réalisation précédent, on peut prévoir au moulage de la résine des réserves pour le logement des pattes pliées qui forment électrodes.

Les composants peuvent être marqués par tamponnage ou par inscription au laser. Leur principal avantage réside dans le fait qu'ils peuvent être livrés en vrac et être placés dans des installations automatiques d'amenée sur chaîne de fabrication de circuit, comportant notamment des bols vibrants.

## Revendications

1. Composant électrique à report direct en surface, noyé dans une masse parallélépipédique d'enrobage protecteur dont certaines surfaces extérieures portent des électrodes de connexion planes, caractérisé en ce que chacune d'au moins deux surfaces parallèles du parallélépipède (6) est équipée d'un élément(4a, 5a ; 4b, 5b) de chacune des deux électrodes (4,5) de connexion du compo-

_sant.

2. Composant électrique selon la revendication 1 comprenant un élément (1) actif ou passif possédant deux terminaisons électriques (2, 3) auxquelles sont raccordées les électrodes (4,5), caractérisé en ce que l'élément est logé dans un boîtier (6) parallélépipédique ouvert par l'une de ses faces (10), les électrodes étant constituées par des feuillards (4,5) conformés en crochets de suspension de l'élément (1) recouvrant chacun l'un des bords opposés (7a,7b) de l'ouverture (10) du boîtier, les feuillards se prolongeant le long des faces (8,9) du boîtier (6) terminées par les bords susdits, et possédant un retour (4b,5b) à l'autre extrémité de ces faces, dirigé sous le boîtier (12) parallèlement à la partie du feuillard (4a, 5a) en appui sur les bords susdits.

3. Composant selon la revendication 2 caractérisé en ce que le volume intérieur du boîtier (6) est au moins partiellement rempli de résine polymérisée (11).

4. Composant selon la revendication 2 ou la revendication 3 caractérisé en ce que le boîtier (6) comporte un couvercle (13) de fermeture de sa face ouverte.

5. Composant selon la revendication 1, caractérisé en ce que le feuillard formant chaque électrode est issu de la masse d'enrobage (20) par la partie médiane d'une face d'extrémité (21) pour l'une des électrodes et de la partie médiane de la face opposée (22) pour l'autre électrode, ce feuillard étant refendu pour former des pattes (23a,23b,23c) repliées contre la face (21) d'où il est issu de part et d'autre de son plan, chaque patte possédant un retour sur la face (20a,20b) du parallélépipéde (20) contigüe à cette face d'extrémité (21).

Fig. 1

Fig. 2

Fig. 3

Fig. 4

**Office européen des brevets**

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | EP-A-162149 (SIEMENS AG)<br>* page 1, lignes 3 - 26 * | 1-3 | H01G1/035 |
| Y | * page 8, lignes 1 - 7; figures 8-16 * | 4 | |
| A | | 5 | |
| | --- | | |
| Y | EP-A-171838 (N.V.PHILIPS GLOEILAMPENFABRIEKEN)<br>* page 3, lignes 2 - 31; figures 5-6 *<br>----- | 4 | |

DOMAINES TECHNIQUES RECHERCHES (Int. Cl.5)

H01L
H01G

Le présent rapport a été établi pour toutes les revendications

| Lieu de la recherche | Date d'achèvement de la recherche | Examinateur |
|---|---|---|
| LA HAYE | 05 MARS 1990 | CRIQUI J.J. |

EPO FORM 1503 03.82 (P0402)